# EUROPÄISCHE PATENTSCHRIFT

(11) **EP 0 954 911 B1**
(45) Veröffentlichungstag und Bekanntmachung des Hinweises auf die Patenterteilung: **22.08.2007**
(21) Anmeldenummer: 97954722.1
(22) Anmeldetag: 30.12.1997
(51) Int. Cl.: H04H 1/00, H03J 1/00, H03J 7/18

(54) **VERFAHREN ZUR AUSWERTUNG VON DIGITALEN SIGNALEN, INSBESONDERE RADIO-DATEN-SIGNALEN**
METHOD FOR EVALUATING DIGITAL SIGNALS, ESPECIALLY RDS SIGNALS
PROCEDE D'EVALUATION DE SIGNAUX NUMERIQUES, EN PARTICULIER DE SIGNAUX RDS

(30) Priorität: 15.01.1997 DE 19701042
(43) Veröffentlichungstag der Anmeldung: 10.11.1999
(73) Patentinhaber: ROBERT BOSCH GMBH, 70442 Stuttgart (DE)
(72) Erfinder: WIETZKE, Joachim, D-31141 Hildesheim (DE); BOMBKA, Dieter, D-31141 Hildesheim (DE); GROEGER, Klaus-Erwin, D-31199 Diekholzen (DE)
(86) Internationale Anmeldenummer: PCT/DE1997/003037
(87) Internationale Veröffentlichungsnummer: WO 1998/032232

(56) Entgegenhaltungen:
- EP-A- 0 497 116
- DE-A- 4 103 061

## Beschreibung

### Stand der Technik

Die Erfindung geht von einem Verfahren zur Auswertung von digitalen Signalen, die über eine andere als eine an einem Rundfunkempfänger eingestellte Sendefrequenz übertragen werden, nach der Gattung des Hauptanspruchs aus.

Aus den "Specifications of the Radio Data System (RDS) for VHF/FM Sound Broadcasting" der European Broadcasting Union vom März 1984 ist es bekannt, neben den Rundfunkprogrammen im Rahmen des Radio-Daten-Systems, kurz RDS, über die Rundfunk-Sendefrequenzen Informationen in Form digitaler Signale zu übertragen. Teil dieser Informationen sind den Sendefrequenzen bzw. den über die Sendefrequenzen übertragenen Programmen zugeordnete Programmkettenkennungen (Programme Identifier PI), die angeben, welches Programm über die jeweilige Sendefrequenz übertragen wird.

Aus der DE-A-41 03 061 sind Rundfunkempfänger bekannt, bei denen die Programmkettenkennungen zum Auffinden von empfangswürdigen Sendefrequenzen genutzt werden, über die das gleiche Programm wie die aktuelle Sendefrequenz übertragen wird. Zur Prüfung solcher alternativer Frequenzen wird die Empfangsfrequenz des Rundfunkempfängers für die Dauer der Prüfung einer alternativen Frequenz, d. h. zur Prüfung ihrer Empfangsfeldstärke und der ihr zugeordneten Programmkettenkennung PI auf die alternative Sendefrequenz umgeschaltet. Die dabei entstehenden Signalunterbrechungen im Bereich von 20 bis 30 ms bzw. 150 bis 300 ms machen sich in Form von Knackgeräuschen störend bemerkbar. Es wird daher vorgeschlagen, in die Signallücken Ersatzsignale einzusetzen, die aus dem der Unterbrechung unmittelbar vorausgehenden Audiosignalabschnitt durch Zwischenspeichern gewonnen werden, und so die Signalunterbrechungen zu verdecken.

EP-A-0 497 116 offenbart ein Verfahren zur Auswertung von Radio-Daten-Signalen, die über eine andere als eine aktuell eingestellte Sendefrequenz übertragen werden. Dazu wird der vorübergehend von der aktuellen auf die alternative Sendefrequenz umgeschaltet. Während der Verweildauer auf der alternativen Frequenz wird eine Datenprobe des digitalen Signals gelesen, wobei die Anzahl der gelesenen Bits des digitalen Signals pro Datenprobe durch eine Höchstdauer von 20 bis 30 Millisekunden der Unterbrechung des Empfangs der aktuellen Sendefrequenz, die Einstellzeit der PLL von ca. 3 bis 7 Millisekunden und gegebenenfalls die Dauer der Bitsynchronisation von 10 Millisekunden begrenzt ist. Das vollständige auszuwertende Datum des über die alternative Sendefrequenz übertragenen Radio-Daten-Signals, im vorliegenden Fall der vollständige PI-Code, wird dadurch gewonnen, daß mehrere Datenproben aus verschiedenen Gruppen und zu verschiedenen Zeitpunkten innerhalb der Gruppen des Radio-Daten-Signals entnommen werden. Durch Verteilung der Datenproben von ca. 20 bis 30 Millisekunden Dauer auf mehrere Gruppen des digitalen Signals wird erreicht, daß die vorübergehenden Umschaltungen sich bei der Wiedergabe des über die aktuell eingestellte Sendefrequenz empfangenen Audioprogramms nicht störend bemerkbar machen.

### Vorteile der Erfindung

Das erfindungsgemäße Verfahren mit den Merkmalen des Hauptanspruchs hat demgegenüber den Vorteil, daß durch die Kürze der Umschaltung von der aktuellen auf die zu prüfende Sendefrequenz, die während der Umschaltung vorgenommene Audiosignalunterbrechung nicht hörbar ist. Außerdem wird der Aufwand zur Aufzeichnung des der Unterbrechung vorhergehenden Audiosignalabschnitts eingespart.

Eine Weiterbildung des Verfahrens stellt durch Variation der zeitlichen Abstände und/oder der Dauer T_{U} der Umschaltung von der aktuellen auf die zu prüfende Frequenz sicher, daß die Umschaltungen auch durch mögliche Sensibilisierungseffekte des menschlichen Gehörs den Höreindruck nicht stören.

### Zeichnung

Ausführungsbeispiele der Erfindung sind in den Zeichnungen dargestellt und werden im folgenden näher erläutert.

Es zeigen
- Figur 1: schematisch den für die Erfindung wesentlichen Teil eines Rundfunkempfängers zur Durchführung des erfindungsgemäßen Verfahrens,
- Figur 2: eine schematische Darstellung zur Verdeutlichung des Ablaufs des erfindungsgemäßen Verfahrens und
- Figur 3: ein Ablaufdiagramm des erfindungsgemäßen Verfahrens.

### Beschreibung der Ausführungsbeispiele

Das erfindungsgemäße Verfahren wird im folgenden anhand eines Rundfunkempfängers zum Empfang von nach dem Radio-Daten-System (RDS) übertragenen Informationen beschrieben, ist jedoch prinzipiell auch auf andere digital übertragene Informationen anwendbar.

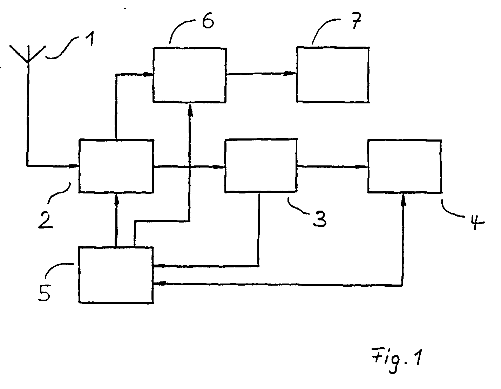

Bei dem in Figur 1 dargestellten Rundfunkempfänger zur Durchführung des erfindungsgemäßen Verfahrens wird ein an einer Empfangsantenne 1 anstehendes Rundfunksignal an ein Empfangsteil 2 weitergeleitet, das über die zum Empfang und zur Demodulation von Rundfunksignalen erforderlichen Mittel, wie einen Antennensignalverstärker, eine einstellbare Phasenregelschleife (PLL) zur Abstimmung des Empfangsteils 2 auf eine bestimmte Sendefrequenz, ein Zwischenfrequenzteil und einen Demodulator zur Demodulation des empfangenen Rundfunksignals verfügt. Die von einer Steuerung 5 angesteuerte Phasenregelschleife ist dabei als Hochgeschwindigkeits-PLL ausgelegt und läßt sich im Bereich weniger µs von einer ersten auf eine zweite Sendefrequenz umschalten. Das am Ausgang des Empfangsteils 2 anstehende Stereo-Multiplexsignal; mit dem die empfangene Sendefrequenz moduliert ist, wird zum einen über eine Mute-Schaltung 6 zur Unterbrechung des wiedergegebenen Audio-Signals an eine Wiedergabeeinheit 7 weitergeleitet, die in bekannter Weise über die zur Wiedergabe des in dem Stereo-Multiplexsignal enthaltenen Audiosignals wie Stereo-Decoder, Verstärker und Lautsprecher verfügt. Die von der Steuerung 5 angesteuerte Mute-Schaltung 6 ist im vorliegenden Fall als steuerbarer Schalter ausgelegt, dessen Ausgang mit einem Speicher, im einfachsten Fall einem Kondensator, verbunden ist. Auf diese Weise werden die Koppelkondensatoren der nachfolgenden Stufen bei Unterbrechung des Audiosignals auf dem zuletzt anliegenden Wert gehalten, so daß Knackgeräusche als Folge von Einschwingvorgängen an den Koppelkondensatoren bei Öffnen und Schließen des Schalters wirkungsvoll vermieden werden.

Das Stereo-Multiplexsignal ist weiterhin dem Eingang eines mit der Steuerung 5 verbunden RDS-Demodulators 3 zur Demodulation des durch das RDS-Signal modulierten 57 kHz-Hilfsträgers des Stereo-Multiplexsignals zugeführt. Der Ausgang des RDS-Demodulators 3 steht mit einem Speicher 4, der im vorliegenden Fall als Ringspeicher ausgeführt ist, zur Speicherung der Bits des RDS-Signals in Verbindung, der seinerseits wiederum mit der Steuerung 5 verbunden ist.

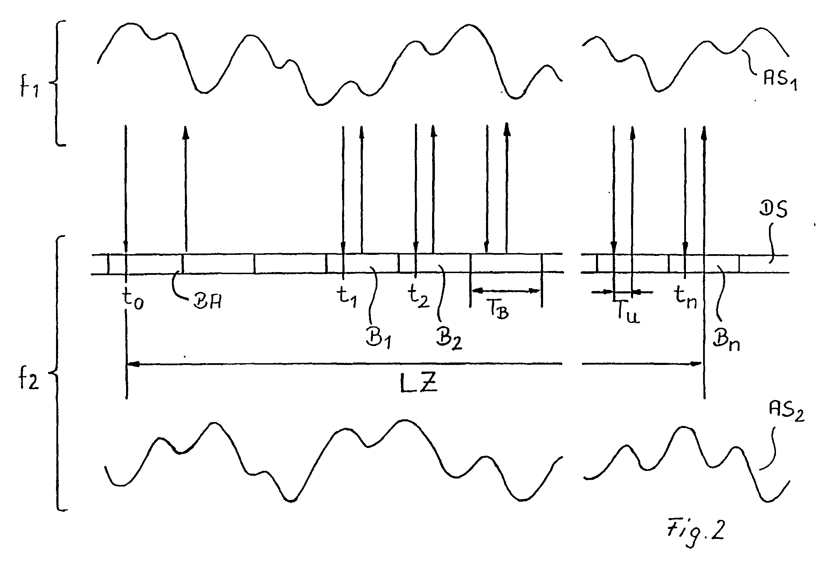

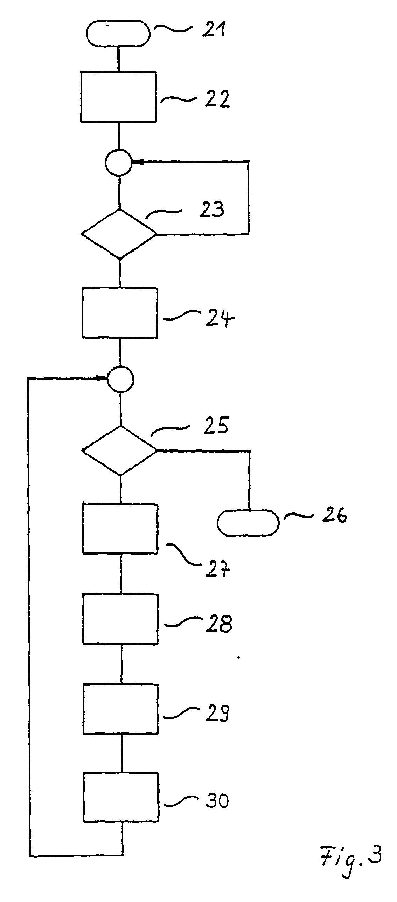

Die Funktionsweise des erfindungsgemäßen Verfahrens wird im folgenden anhand eines Beispiels unter Zuhilfenahme der Figuren 2 und 3 beschrieben, wobei von folgender Situation ausgegangen wird.

Das Empfangsteil 2 des Rundfunkempfängers ist auf eine erste Sendefreqenz f₁ abgestimmt, über die ein erstes Programm, oder allgemein ein erstes analoges Signal AS₁ übertragen wird. Im Empfänger ist eine zweite Sendefrequenz f₂ bekannt, die daraufhin überprüft werden soll, ob über sie das gleiche Programm AS₂ übertragen wird wie über die erste Sendefrequenz f₁. Bei den auszuwertenden Daten handelt es sich somit um die über das Radio-Daten-System übertragenen Programmkettenkennungen (PI), die anzeigen, welches Programm über eine bestimmte Sendefrequenz übertragen wird. Das über die zweite Sendefrequenz f₂ übertragene Radiodatensignal ist in Figur 2 allgemein als digitales Signal DS bezeichnet.

Der Ablauf des erfindungsgemäßen Verfahrens beginnt mit Schritt 21 des in Figur 3 dargestellten Ablaufdiagramms. Zum Zeitpunkt t₀ wird die Phasenregelschleife des Empfangsteils 2 auf ein Signal der Steuerung 5 von der ersten Sendefrequenz f₁ auf die zweite Sendefrequenz f₂ umgeschaltet (Schritt 22 in Figur 3) und die Wiedergabe des Programms mittels der Mute-Schaltung 6 unterbrochen. Die Phasenregelschleife bleibt solange auf die zweite Sendefrequenz f₂ umgeschaltet, bis durch den RDS-Demodulator 3 der Anfang BA eines Bits des digitalen Signals DS erkannt ist, was in Schritt 23 abgefragt wird. Ist ein Bitanfang BA erkannt worden, so wird die Phasenregelschleife des Empfangsteils 2 bei 24 auf ein Signal der Steuerung 5 wieder auf die erste Sendefrequenz f₁ zurückgeschaltet und die Wiedergabe des empfangenen Audioprogramms über die Mute-Schaltung 6 fortgesetzt.

Aus der Kenntnis der zeitlichen Lage eines Bitanfangs BA und der Dauer T_{B} eines Bits bzw. der Datenrate des digitalen Signals DS wird die zeitliche Lage der weiteren Bits des digitalen Signals bestimmt. Bei 27 wird ein weiterer Umschaltzeitpunkt t₁ so bestimmt, daß die Umschaltdauer T_{U} während der die Phasenregelschleife des Empfangsteils 2 auf die zweite Sendefrequenz f₂ umgeschaltet bleibt, innerhalb der Dauer T_{B} eines folgenden Bits des digitalen Signals liegt. Die Umschaltdauer T_{U} ist dabei so lange bemessen, daß ein sicheres Einrasten der PLL auf die zweite Sendefrequenz f₂ . und eine sichere Bestimmung des am Ausgang des Demodulators 3 anliegenden Bits des digitalen Signals DS gewährleistet ist. Andererseits ist die Umschaltdauer T_{U} so kurz ausgelegt, daß der Umschaltvorgang auch bei schnell wiederkehrenden Umschaltvorgängen nicht hörbar wird. Die Umschaltdauer T_{U} liegt dabei im Bereich von ungefähr 80 µs.

Bei 28 wird die Phasenregelschleife des Empfangsteils 2 zum berechneten Zeitpunkt t₁ auf die zweite Sendefrequenz f₂ umgeschaltet und gleichzeitig die Audiosignalwiedergabe über die Mute-Schaltung 6 unterbrochen. Das am Ausgang des Demodulators 3 anstehende Bit des digitalen Signals DS wird in den Speicher 4 eingelesen (Schritt 29), worauf nach Ablauf der Umschaltdauer T_{U} die Phasenregelschleife bei 30 auf die erste Sendefrequenz f₁ zurückgeschaltet und die Audiosignalwiedergabe über die Mute-Schaltung 6 fortgesetzt wird.

Das Verfahren wird bei 27 mit der Bestimmung eines weiteren Umschaltzeitpunktes tᵢ (i = 2,...,n) fortgesetzt, wobei der weitere Umschaltzeitpunkt tᵢ so gewählt wird, daß die Umschaltdauer T_{U} der weiteren Umschaltung innerhalb der Dauer T_{B} des unmittelbar auf das zuletzt gelesene Bit Bᵢ₋₁ folgenden Bits Bᵢ (i = 2,...,n) des digitalen Signals liegt.

Das Verfahren wird solange fortgesetzt, bis eine Anzahl n von Umschaltungen stattgefunden hat und somit n aufeinanderfolgende Bits des digitalen Signals DS im Speicher 4 abgelegt sind. Das Erreichen der vorgegebenen Zahl n, die der Anzahl der in einem Block des digitalen Signals enthaltenen Bits entspricht, im Fall von RDS also 26 Bits, wird als Abbruchbedingung bei 25 überprüft, worauf der Lesezyklus LZ bei 26 beendet wird.

Bei einer Variante des erfindungsgemäßen Verfahrens ist es vorgesehen, daß nach Erkennung eines Bitanfangs BA des digitalen Signals DS bei 24 die Phasenregelschleife des Empfangsteils 2 nicht direkt auf die erste Sendefrequenz f₁ zurückschaltet, sondern das Bit des digitalen Signals DS, dessen Anfang BA erkannt worden ist, als Bit B₁ in den Speicher 4 eingelesen wird. Das Verfahren wird dann bei Schritt 27 mit der Berechnung eines weiteren Umschaltzeitpunktes tᵢ (i = 2,...,n) forgesetzt, so daß durch den Wegfall der Rückschaltung von der zweiten Sendefrequenz f₂ auf die erste Sendefrequenz f₁ nach erkanntem Bitanfang BA auch die Umschaltung zum Zeitpunkt t₁ und somit zwei Frequenzwechsel pro Lesezyklus LZ entfallen.

Bei einer weiteren Variante des erfindungsgemäßen Verfahrens ist es vorgesehen, daß die vorübergehenden Umschaltungen von der ersten Sendefrequenz f₁ auf die zweite Sendefrequenz f₂ nicht in gleichbleibenden, sondern in wechselnden Zeitabständen erfolgen, was nichts anderes heißt, als daß die Umschaltungen zu wechselnden Zeitpunkten innerhalb der Dauer T_{B} der jeweiligen Bits Bᵢ (i = 1,...,n) erfolgen. Weiterhin kann es alternativ oder ergänzend dazu vorgesehen sein, daß die Umschaltdauern T_{U} innerhalb der durch eine Mindestdauer, die eine zuverlässige Auswertung des jeweiligen Bits zuläßt, und einer Höchstdauer, innerhalb der die Unterbrechung nicht hörbar wird, vorgegebenen Grenzen verändert wird. Dem liegt die Überlegung zugrunde, daß die periodischen vorübergehenden Frequenzumschaltungen wenn auch nicht bewußt akustisch wahrnehmbar, so doch z. B. als Folge von Sensibilisierungseffekten des menschlichen Gehörs den Höreindruck des Hörers beeinträchtigen könnten. Durch die beispielsweise zufällige Variation der Zeitabstände, in denen die Frequenzumschaltungen erfolgen und/oder der Umschaltdauern T_{U} wird solchen möglichen Effekten vorgebeugt.

An den Lesezyklus LZ schließt die Auswertung der im Speicher 4 abgelegten Daten an, wobei zunächst in bekannter Weise der Blockanfang innerhalb des gespeicherten Signalabschnittes bestimmt wird. Aus der Kenntnis des Blockanfangs wird die Lage des auszuwertenden Datums, im vorliegenden Fall des PI-Codes, bestimmt und das Datum ausgewertet.

Alternativ kann es auch vorgesehen sein, daß die Auswertung der im Speicher 4 abgelegten digitalen Informationen zeitlich parallel zum Einlesen der Informationen erfolgt.

## Patentansprüche

1. Verfahren zur Auswertung von digitalen Signalen, die neben einem Rundfunkprogramm auf einer anderen als einer aktuell an einem Empfänger eingestellten Sendefrequenz übertragen werden, insbesondere von Radio-Daten-Signalen,
wobei innerhalb eines Lesezyklus (LZ) die Empfangsfrequenz (f) des Empfängers zu vorgegebenen Zeitpunkten (t0, t1,..., tn) vorübergehend von der ursprünglich eingestellten Frequenz (f1) auf die andere Frequenz (f2) umgeschaltet wird,
wobei bei einem ersten vorübergehenden Umschalten auf die andere Frequenz (f2) die andere Frequenz (f2) solange eingestellt bleibt, bis der Bitanfang (BA) eines Bits des digitalen Signals (DS) erkannt ist,
wobei die weiteren vorübergehenden Umschaltungen auf die andere Frequenz (f2), also sowohl die Umschaltungen auf die andere Frequenz (f2), als auch die Rückschaltungen von der anderen Frequenz auf die ursprünglich eingestellte Frequenz (f1), jeweils während der Dauer (TB) jedes einzelnen von aufeinanderfolgenden Bits (B1, B2,..., Bn) des digitalen Signals (DS) erfolgen, wobei die Zeitpunkte t1,..., tn) für die weiteren Umschaltungen aus dem erkannten Bitanfang (BA) und der vorgegebenen Dauer (TB) der Bits des digitalen Signals (DS) abgeleitet werden,
und wobei die während der weiteren vorübergehenden Umschaltungen empfangenen Bits (B1, B2,..., Bn) des digitalen Signals zwischengespeichert und in einem Auswertezyklus (AZ) ausgewertet werden.

2. Verfahren nach Anspruch 1,
**dadurch gekennzeichnet,**
**daß** bei der ersten vorübergehenden Umschaltung der Empfangsfrequenz (f) des Empfängers die andere Frequenz (f2) solange eingestellt bleibt, bis das auf den erkannten Bitanfang (BA) folgende Bit des digitalen Signals (DS) gelesen ist.

3. Verfahren nach einem der Ansprüche 1 oder 2,
**dadurch gekennzeichnet,**
**daß** die vorübergehenden Umschaltungen der Empfangsfrequenz (f) zu wechselnden Zeitpunkten (t0, t1,...,tn) und/oder für wechselnde Zeitdauern (Tu) während der Dauer (TB) eines Bits des digitalen Signals (DS) erfolgt.

4. Verfahren nach einem der Ansprüche 1 bis 3,
**dadurch gekennzeichnet,**
**daß** die auszuwertenden digitalen Signale (DS) über das Radio-Daten-System übertragene Programm-Kennungen (PI) sind.

5. Verfahren nach einem der Ansprüche 1 bis 4,
**dadurch gekennzeichnet,**
**daß** während der Umschaltung des Empfängers auf die andere Sendefrequenz (f2) die Wiedergabe eines empfangenen Programms unterbrochen wird.

## Claims

1. Method for evaluating digital signals which are transmitted in addition to a broadcast radio programme on a different transmission frequency from the one which is currently selected on a receiver, particularly radio data signals,
where within a read cycle (LZ) the reception frequency (fn) of the receiver is temporarily changed over from the originally selected frequency (f1) to the other frequency (f2) at prescribed instants (t0, t1, ..., tn),
where a first temporary changeover operation to the other frequency (f2) involves the other frequency (f2) remaining selected until the bit start (BA) of a bit in the digital signal (DS) is identified,
where the further temporary changeover operations to the other frequency (f2), that is to say both the changeover operations to the other frequency (f2) and the return operations from the other frequency to the originally selected frequency (f1), respectively take place during the continuance (TB) of each individual one of successive bits (B1, B2, ..., Bn) in the digital signal (DS), the instants (t1, ..., tn) for the further changeover operations being derived from the identified bit start (BA) and the prescribed continuance (TB) of the bits in the digital signal (DS),
and where the bits (B1, B2, ..., Bn) in the digital signal which are received during the further temporary changeover operations are buffer-stored and are evaluated in an evaluation cycle (AZ).

2. Method according to Claim 1,
**characterized**
**in that** the first temporary changeover operation for the reception frequency (fn) of the receiver involves the other frequency (f2) remaining selected until that bit in the digital signal (DS) which follows the identified bit start (BA) has been read.

3. Method according to one of Claims 1 and 2,
**characterized**
**in that** the temporary changeover operations for the reception frequency (fn) take place at changing instants (t0, t1, ..., tn) and/or for changing periods of time (Tu) during the continuance (TB) of a bit in the digital signal (DS).

4. Method according to one of Claims 1 to 3,
**characterized**
**in that** the digital signals (DS) to be evaluated are programme identifiers (PI) transmitted using the radio data system.

5. Method according to one of Claims 1 to 4,
**characterized**
**in that** while the receiver is changing over to the other transmission frequency (f2) the reproduction of a received programme is interrupted.

## Revendications

1. Procédé d'exploitation de signaux numériques transmis en plus d'un programme de radiodiffusion sur une fréquence d'émission autre qu'une fréquence d'émission réglée actuellement sur un récepteur, en particulier de signaux RDS (Radio Data System),
selon lequel
dans un cycle de lecture (LZ), la fréquence d'entrée (f) du récepteur est commutée à des instants prédéterminés (t0, t1,..., tn) temporairement de la fréquence initialement réglée (f1) sur l'autre fréquence (f2),
lors d'une première commutation temporaire sur l'autre fréquence (f2), celle-ci reste réglée jusqu'à ce que le début de bit (BA) d'un bit du signal numérique (DS) soit reconnu,
les autres commutations temporaires sur l'autre fréquence (f2), donc aussi bien les commutations sur l'autre fréquence (f2) que les rétrogradations des autres fréquences sur la fréquence initialement réglée (f1), s'effectuent respectivement pendant la durée (TB) de chacun des bits successifs séparés (B1, B2,..., Bn) du signal numérique (DS), et les instants (t1,..., tn) pour les autres commutations sont déduits du début de bit reconnu (BA) et de la durée prédéterminée (TB) des bits du signal numérique (DS), et
les bits (B1, B2,..., Bn) du signal numérique reçus pendant les autres commutations temporaires sont enregistrés dans la mémoire temporaire et exploités dans un cycle d'exploitation (AZ).

2. Procédé selon la revendication 1,
**caractérisé en ce que**
lors de la première commutation temporaire de la fréquence d'entrée (f) du récepteur, l'autre fréquence (f2) reste réglée jusqu'à ce que le bit du signal numérique (DS), succédant au début de bit reconnu (BA) soit lu.

3. Procédé selon l'une quelconque des revendications 1 ou 2,
**caractérisé en ce que**
les commutations temporaires de la fréquence d'entrée (f) s'effectuent à des instants aléatoires (t0, t1,..., tn) et/ou pour des durées variables (Tu) pendant la durée (TB) d'un bit du signal numérique (DS).

4. Procédé selon l'une quelconque des revendications 1 à 3,
**caractérisé en ce que**
les signaux numériques (DS) à exploiter par le système RDS (Radio Data System) sont des identifiants de programme (PI).

5. Procédé selon l'une quelconque des revendications 1 à 4,
**caractérisé en ce que**
pendant la commutation du récepteur sur l'autre fréquence d'émission (f2), la restitution d'un programme reçu est interrompue.
